# EUROPÄISCHE PATENTSCHRIFT

(11) **EP 0 653 381 B1**
(45) Veröffentlichungstag und Bekanntmachung des Hinweises auf die Patenterteilung: **29.04.1998**
(21) Anmeldenummer: 94113614.5
(22) Anmeldetag: 31.08.1994
(51) Int. Cl.: C03B 19/06

(54) **Formkörper mit hohem Gehalt an Siliziumdioxid und Verfahren zur Herstellung solcher Formkörper**
Body with high silica content and method for making such a body
Corps avec haute teneur en oxide de silice et procédé de fabrication ledit corps

(30) Priorität: 12.11.1993 DE 4338807
(43) Veröffentlichungstag der Anmeldung: 17.05.1995
(73) Patentinhaber: Heraeus Quarzglas GmbH, D-63405 Hanau (DE)
(72) Erfinder: Moritz, Stephan, D-63526 Erlensee (DE); Englisch, Wolfgang, Dr., D-65779 Kelkheim (DE)
(74) Vertreter: Grimm, Ekkehard, Dipl.-Phys.

(56) Entgegenhaltungen:
- EP-A- 0 475 549
- DE-A- 2 218 766
- DE-C- 543 957

## Beschreibung

Die Erfindung betrifft einen Formkörper aus amorphem Siliziumdioxid, der eine chemische Reinheit von mindestens 99,9 % und einen Cristobalitgehalt von höchstens 1 % besitzt und der gasundurchlässig ist. Darüberhinaus betrifft die Erfindung ein Verfahren zum Herstellen eines gasundurchlässigen Formkörpers aus amorphem Siliziumdioxid, der eine chemische Reinheit von mindestens 99,9 % besitzt und dessen Cristobalitgehalt höchstens 1 % beträgt, wobei als Ausgangsmaterial amorphes Quarzglas einer Reinheit von mindestens 99,9 % zu einem Pulver mit einer Teilchengröße unter 70 µm zerkleinert, und aus dem Pulver ein Schlicker bereitgestellt, der Schlicker zur Erzeugung eines Formkörper-Rohlings in eine poröse, dem Formkörper entsprechende Form eingefüllt und darin eine vorbestimmte Zeit belassen, nach dem Entfernen der Form der Formkörper-Rohling getrocknet und anschließend in einem Ofen auf eine Temperatur über 1200 °C erhitzt und danach abgekühlt wird.

Formkörper mit einem hohen Gehalt an Siliziumdioxid, der über 99,56 % liegt, werden auf vielen technischen Gebieten benutzt. Als Beispiele für solche Anwendungsgebiete seien erwähnt: Gießrohre für das Stranggießen von Stahl oder Nichteisenmetallen, Kerne für Herstellung von Druckund Feingußteilen, Tiegel für das Ziehen von Kristallen, Flansche für Diffusionsrohre, in denen z.B. Halbleiter-Dotierprozesse durchgeführt werden. Bei den meisten Anwendungen wird von den Formkörpern eine hohe Beständigkeit bei Temperaturen im Bereich von 1000 °C gefordert, bisweilen auch eine hohe Temperaturwechselbeständigkeit. Um einen wiederholten Einsatz der Formkörper bei Temperaturen oberhalb von 1100 °C zu ermöglichen, sollte ihr Cristobalitgehalt wegen der Cristobalitbildung ab etwa 1100 °C höchstens wenige Prozent betragen. Die Dichte der nach dem Schlickergießverfahren hergestellten und üblicherweise bei Temperaturen im Bereich von 1100 °C bis maximal 1250 °C gesinterten Formkörper (siehe hierzu Keramische Zeitschrift 38. Jahrgang, Nr. 8, 1986, S. 442-445; EP-A-0 475 549) liegt im Bereich von 85 % bis 90 % der theoretischen Dichte von Quarzglas. Die Kaltbiegefestigkeit wird mit 15 N/mm² angegeben.

Formkörper mit einer Dichte, die etwa 95 % der theoretischen Dichte von Quarzglas beträgt, werden durch Erhitzen von Quarzzitsand in rotierenden Formen mittels elektrischen Lichtbögen erhalten (DE-C- 543 957). Diese Formkörper sind, bedingt durch ihr Herstellungsverfahren, rotationssymmetrisch und müssen ggf. noch mechanisch weiterbearbeitet werden. Sie besitzen eine Kaltbiegefestigkeit von etwa 65 N/mm².

Aus der DE-OS 22 18 766 sind dünnwandige Gefäße, insbesondere Tiegel, zum Ziehen von Einkristallen bekannt, die aus amorphem Siliziumdioxid hoher Reinheit bestehen. Der Cristobalitgehalt dieser Gefäße beträgt höchstens 1 % und sie sind, bedingt durch ihr Herstellungsverfahren, gasundurchlässig und durchsichtig. Sie werden nach dem Schlickergießverfahren hergestellt. Als Ausgangsmaterial wird glasige Kieselsäure einer chemischen Reinheit von mindestens 99,95 % verwendet, die in üblichen Mühlen zu einem Pulver zerkleinert wird, wobei die Quarzteilchen nicht größer als 200 µm sein sollten und die durchschnittliche Teilchengröße zwischen 1 und 70 µm liegen sollte. Aus diesem Pulver wird unter Zusatz von destilliertem Wasser ein Schlicker hergestellt. Der Schlicker wird zur Erzeugung eines Tiegel-Rohlings in einer porösen, beispielsweise aus Gips bestehenden, und dem herzustellenden Tiegel entsprechenden Form gegossen und darin eine ausreichend lange Zeit belassen, um eine gewünschte Wandstärke entstehen zu lassen. Sobald der Tiegel genügend fest ist, wird er aus der Form genommen und teilweise getrocknet. Die vollständige Trocknung erfolgt in einem Erhitzungsraum bei etwa 177 °C. Zur Entfernung von allen verbrennbaren Bestandteilen, wie beispielsweise Polyurethangummi-Abrieb, die beim Zerkleinern in der Mühle entstehen, und von absorbiertem Wasser wird der Tiegel langsam bis auf 1150 °C erhitzt. Nach Abkühlung auf Zimmertemperatur wird der Tiegel auf einem Graphitdorn in einer Heizkammer unter Heliumatmosphäre etwa 3 bis 4 Minuten lang auf etwa 1680 °C erhitzt, bis der Tiegel durchsichtig ist. Danach läßt man den Tiegel in der Heliumatmosphäre für etwa 1/2 Minute auf etwa 1480 °C abkühlen, um ihn dann mittels einer Zange vom Graphitdorn abzunehmen und auf Zimmertemperatur abkühlen zu lassen. Um die Cristobalitbildung möglichst gering, d.h. unterhalb 1 %, zu halten, wird der Tiegel dem Hochtemperaturbereich über 1200 °C während des Heiz und Abkühlvorgangs höchstens für eine Zeitdauer von 10 Minuten ausgesetzt. Die Wandstärke der so erhaltenen Tiegel liegt zwischen 2 und 4 mm.

Die Aufgabe der Erfindung besteht darin, Formkörper aus amorphem Siliziumdioxid bereitzustellen, die eine hohe Präzision aufweisen können, die sowohl von kleinem als auch großem Format und von einfacher bis komplizierter Formgebung sein können, die eine chemische Reinheit von mindestens 99,9 % besitzen, die gasundurchlässig sind, die eine hohe Kaltbiegefestigkeit, geringe Wärmeleitfähigkeit und geringe Wärmeabstrahlung besitzen, die temperaturwechselbeständig und wiederholt oder auch langzeitig Temperaturen im Bereich von 1000 bis 1300 °C aussetzbar sind und die scharfkantig, ohne verlaufende Verbindungsstellen verschweißbar sind und die eine geringe spektrale Transmission vom ultravioletten bis in den mittleren infraroten Spektralbereich aufweisen.

Der Erfindung liegt weiterhin die Aufgabe zugrunde, ein Verfahren anzugeben, das ermöglicht, auf technisch einfache und preiswerte Weise aus amorphem Siliziumdioxid bestehende Formkörper beliebigen Formats mit Wandstärken bis zu 100 mm herzustellen, die mit hoher Präzision herstellbar sind, eine hohe Kaltbiegefestigkeit, eine geringe Wärmeleitfähigkeit und Wärmeausdehnung besitzen, die gasundurchlässig sind und deren Strahlungstransmission gering ist, insbesondere auch im nahen und mittleren Infrarotbereich.

Die der Erfindung zugrundeliegende Aufgabe wird für einen Formkörper aus amorphem Siliziumdioxid, der eine chemische Reinheit von mindestens 99,9 % und einen Cristobalitgehalt von höchstens 1 % besitzt und der gasundurchlässig ist, dadurch gelöst, daß er opak ist, Poren enthält, eine Mindestwandstärke von 0,1 mm besitzt, bei einer Wandstärke von 1 mm seine direkte spektrale Transmission im Wellenlängenbereich von λ = 190 nm bis λ = 2650 nm praktisch konstant ist und unterhalb von 10 % liegt, und daß er eine Dichte aufweist, die wenigstens 2,15 g/cm³ beträgt. Die Gasundurchlässigkeit bezieht sich dabei auf normale Raumtemperatur, weil Quarzglas bei dieser Temperatur keine technisch merkbare Gasundurchlässigkeit besitzt.

Der erfindungsgemäße Formkörper zeichnet sich bevorzugt dadurch aus, daß mindestens 80 % der Poren eine maximale Porenabmessung von weniger als 20 µm aufweisen. Vorteilhafterweise beträgt die maximale Porenabmessung weniger als 10 µm. Der Porengehalt der Formkörper liegt bevorzugt im Bereich von 0,5 bis 2,5 % pro Volumeneinheit.

Die minimale Wandstärke der erfindungsgemäßen Formkörper wird durch die maximale Porenabmessung vorgegeben, wobei aus Festigkeits- und Dichtigkeitsgründen die minimale Wandstärke etwa das 3- bis 5-fache der maximalen Porenabmessung beträgt, also bei etwa 0,1 mm liegt.

Erfindungsgemäße Formkörper zeichnen sich vorteilhaft dadurch aus, daß ihre Kaltbiegefestigkeit für eine Querschnittsfläche von 4 mm x 4 mm mindestens 60 N/mm² beträgt, die erheblich über derjenigen bekannter opaker Formkörper aus amorphem Siliziumdioxid liegt und mit der von transparenten Quarzglas-Formkörpern vergleichbar ist. In einzelnen Fällen wurden sogar Kaltbiegefestigkeiten erreicht, die über 90 N/mm² lagen.

Gegenüber handelsüblichen, Poren enthaltenden opaken Formkörpern besitzen die Formkörper gemäß der Erfindung bei einer Wandstärke von 1 mm eine praktisch konstante und unterhalb von 10% liegende direkte spektrale Transmission, - d.h. die spektrale Transmission ohne Erfassung eventueller Streustrahlung -, im Wellenlängenbereich von λ = 190 nm bis λ = 2650 nm, was sie z.B. zur Filterung auch im nahen und mittleren Infrarotspektralbereich geeignet macht, d.h. um gegen diese Strahlung empfindliche Körper abzuschirmen.

Bevorzugt besitzen die erfindungsgemäßen Formkörper eine Wandstärke im Bereich von 1 bis 100 mm. Sie eignen sich besonders aufgrund ihrer Biegefestigkeit, Temperaturbeständigkeit und ihrer hohen chemischen Reinheit als Tragevorrichtung oder als Unterlage für hochreine Körper, wie beispielsweise Silizium-Wafer, die einer Hochtemperaturbehandlung bis zu 1300 °C unterworfen werden. Auch als Bauelemente in oder für Reaktoren aus höchstreinem Quarzglas, in denen Silizium-Halbzeug für Halbleiterbauelemente behandelt werden, eignen sich die erfindungsgemäßen Formkörper vorteilhaft. Sie können bevorzugt als Hohlkörper ausgebildet sein, insbesondere in Form eines Flansches oder Tiegels, wobei die Tiegel beispielsweise zum Kalzinieren anorganischer Substanzen, wie Leuchtstoffen, oder als Schmelztiegel, beispielsweise für Gold, dienen können. Dabei ist wegen der hohen chemischen Reinheit der Formkörper keine Verunreinigung des in ihnen zu behandelnden Gutes auch bei hohen Temperaturen zu befürchten. Als Flansche ausgebildete Formkörper gemäß der Erfindung lassen sich gut beispielsweise an Behältern aus transparentem Quarzglas anschweißen, wobei sich in vorteilhafter Weise exakte, scharfkantige und nicht verlaufende Verbindungsstellen ergeben.

Formkörper gemäß der Erfindung werden vorteilhafterweise nach dem eingangs charakterisierten Schlickergießverfahren hergestellt. Dieses Schlickergießverfahren zeichnet sich erfindungsgemäß dadurch aus, daß zur Herstellung eines opaken, Poren enthaltenden Formkörpers, dessen Mindestwandstärke 0.1 mm beträgt und dessen direkte spektrale Transmission bei einer Wandstärke von 1 mm im Wellenlängenbereich λ = 190 nm bis λ = 2650 nm praktisch konstant und unterhalb von 10 % liegt, der Schlicker vor dem Einfüllen in die poröse Form während einer Zeitdauer von 1 bis 240 Stunden, abhängig von der Schlickermenge, durch fortwährende Bewegung stabilisiert, der trockene Formkörper-Rohling im Ofen mit einer Aufheizgeschwindigkeit von 5 bis 60 K/min auf eine Sintertemperatur im Bereich von 1350 bis 1450 °C aufgeheizt, einer Temperatur von über 1300°C während einer Zeitdauer von mindestens 40 min ausgesetzt und der gesinterte Formkörper mit einer Abkühlgeschwindigkeit von mehr als 5 K/min bis auf eine Temperatur von etwa 1000 °C abgekühlt wird. Diese Mindestzeitdauer, während der der getrocknete Formkörper-Rohling einer Temperatur von über 1300 °C während einer Zeitdauer von mindestens 40 min ausgesetzt wird, ergibt sich aus der Summe folgender Zeiten:
1. der Zeitdauer, während der der Formkörper-Rohling von 1300 °C auf Sintertemperatur aufgeheizt wird;
2. der Zeitdauer, während der der Formkörper-Rohling auf der Sintertemperatur gehalten wird;
3. der Zeitdauer, während der der Formkörper-Rohling von der Sintertemperatur auf 1300 °C abgekühlt wird.

Gegenüber bekannten Schlickergießverfahren zur Herstellung von Formkörpern zeichnet sich das erfindungsgemäße Verfahren einerseits durch die hohe Sintertemperatur von 1350 bis 1450 °C aus, die um wenigstens 100 °C über den bisher angewandten Sintertemperaturen von 1100 bis 1250 °C liegt, andererseits durch die Zeitdauer von mindestens 40 min während der der Formkörper-Rohling einer Temperatur über 1300 °C ausgesetzt wird. Diese Zeitdauer ist mindestens um das Vierfache länger als sie zur Herstellung transparenter Formkörper aus Siliziumdioxid nach dem bekannten Schlickergießverfahren (DE-OS 22 18 766) als maximale Zeitdauer, die nicht überschritten werden sollte, angegeben wird. Das Überraschende ist, daß die nach dem erfindungsgemäßen Verfahren hergestellten Formkörper einen Cristobalitgehalt von höchstens 1 % aufweisen.

Als Ausgangsmaterial wird hochreines, amorphes Siliziumdioxid mit einer chemischen Reinheit von 99,9% eingesetzt, das in an sich bekannter Weise, beispielsweise aus Quarzsand oder Bergkristall, hergestellt wird. Für das erfindungsgemäße Verfahren können vorzugsweise als Ausgangsmaterial auch Quarzglasabfälle, wie Quarzglasbruch, verwendet werden, wie sie z.B. bei der Herstellung von Reaktoren für die Behandlung von Halbleiterbauelementen oder anderer Quarzglasapparaturen anfallen, sofern die Bedingung der chemischen Reinheit von mindestens 99,9 % erfüllt ist. Diese Abfälle, die bisher entsorgt wurden, können also erneut zur Herstellung von Formkörpern genutzt werden, was zu einer nicht vernachlässigbaren Rohstoff- und Kostenersparnis führt, weil derartige Abfälle hinsichtlich der chemischen Reinheit nicht nochmals teuren Reinigungsprozessen unterworfen werden müssen.

Die Zerkleinerung des Ausgangsmaterials erfolgt mit an sich bekannten Vorrichtungen, wobei darauf zu achten ist, daß keine wesentlichen Mengen an nichtentfernbaren Verunreinigungen in das herzustellende Pulver gelangen.

Bevorzugt wird ein Schlicker mit einem ph-Wert zwischen 3 und 5 verwendet, der in die Form eingefüllt wird. Der Schlicker wird bevorzugt vor dem Einfüllen in die Form kurzzeitig einem Vakuum ausgesetzt, um in ihm eventuell enthaltene Luftblasen zu entfernen.

Weiterhin wird bevorzugt während des Einfüllens des Schlickers in die Form und/oder seines Belassens in der Form zwischen freier Schlickeroberfläche und nicht mit Schlicker benetzter Außenoberfläche der Form eine Druckdifferenz aufrechtzuerhalten, derart, daß der Druck an der Außenoberfläche niedriger als an der freien Schlickeroberfläche ist. Verwendet man Gips als Werkstoff für die Form, so wird bevorzugt, an der Außenoberfläche der Form einen Druck von weniger als 0,8 bar aufrechtzuerhalten. Dies wird bevorzugt in einfacher Weise dadurch bewerkstelligt, daß die Form in einen Behälter eingesetzt wird, der auf einem Druck unter Atmosphärendruck gehalten wird. Der Schlicker kann, wenn die Druckdifferenz vergrö ßert werden soll, unter Überdruck, d.h. im Druckgießverfahren, in die Form eingefüllt werden. Das Druckgießverfahren zum Einbringen des Schlickers in die Form empfiehlt sich für den Fall, daß als Werkstoff für die Form ein poröser Kunststoff verwendet wird. Bevorzugt wird, den Schlicker zur Bildung eines Formkörper-Rohlings für eine Zeitdauer von 5 bis 400 min in der Form zu belassen. Danach wird der Formkörper-Rohling zur Trocknung vorzugsweise von Raumtemperatur auf etwa 300 °C erhitzt, wobei vorzugsweise die Temperatur stufenweise auf 300 °C erhöht wird. Bevorzugt werden, die Höhe der Temperaturstufen im Temperaturbereich unterhalb 100 °C niedriger als im Temperaturbereich von 100 bis 300 C zu wählen. Besonders gute Ergebnisse der Trocknung werden erzielt, wenn sie bevorzugt unter Vakuum durchgeführt wird, wozu ein handelsüblicher Vakuum-Trockenschrank verwendet wird. Um eine vollständige Trocknung sicherzustellen und gleichzeitig auch eventuelle organische Verunreinigungen, die beim Zerkleinern des Ausgangsmaterials als Abrieb von der Auskleidung des Zerkleinerungsgeräts in das Pulver und damit in den Schlicker gelangt sein könnten, zu entfernen, wird der Formkörper-Rohling bevorzugt auf eine Temperatur im Bereich von 900 bis 1100 °C erhitzt und auf dieser Temperatur während einer Zeitdauer von 30 bis 200 min gehalten. Der nunmehr vorliegende Formkörper-Rohling wird dann in einem Ofen, wie oben bereits erwähnt, mit einer Aufheizgeschwindigkeit von 5 bis 60 K/min auf die Sintertemperatur im Bereich von 1350 bis 1450 °C erhitzt und in Abhängigkeit von der Aufheizgeschwindigkeit eine vorgegebene Zeitdauer auf der Sintertemperatur gehalten und anschließend mit einer Abkühlgeschwindigketi von mehr als 5 K/min bis auf eine Temperatur von etwa 1000 °C abgekühlt. Die Zeitdauer, während der der Formkörper-Rohling auf der Sintertemperatur gehalten wird, wird vorzugsweise um so länger gewählt, je größer die Aufheizgeschwindigkeit ist. Die weitere Abkühlung im Ofen kann beliebig schnell oder auch langsam erfolgen, da dies keinen merkbaren Einfluß auf die igenschaften des Formkörpers hat. Bevorzugt wird zur Hochtemperatursinterung des Formkörper-Rohlings im Ofen eine oxidierende Atmosphäre aufrechterhalten, was das Verfahren wesentlich vereinfacht.

Während der Trocknung, der Temperaturbehandlung im Bereich von 900 bis 1100 °C, der Sinterung und der Abkühlung ist der Formkörper-Rohling bzw. der Formkörper auf einer Unterlage, beispielsweise aus chemisch hochreinem, rekristallisiertem Siliziumkarbid, angeordnet, also auf einem Werkstoff, der nicht mit dem amorphen Siliziumdioxid des Formkörpers reagiert.

Bei der Herstellung von Formkörpern mit sehr komplizierter Formgebung, wie z.B. Formkörpern mit Hinterschneidungen, wurde beobachtet, daß der abgekühlte Formkörper im Bereich solcher Stellen eine dünne rauhe Oberflächenschicht aufwies; diese Oberflächenschicht wird dann bevorzugt mechanisch oder durch kurzzeitige Behandlung mittels Fluorwasserstoffsäure abgetragen.

Nachfolgend wird der erfindungsgemäße Formkörper sowie das erfindungsgemäße Verfahren weiterhin erläutert, und zwar unter Bezugnahme auf die Zeichnungen. In den Zeichnungen zeigen:

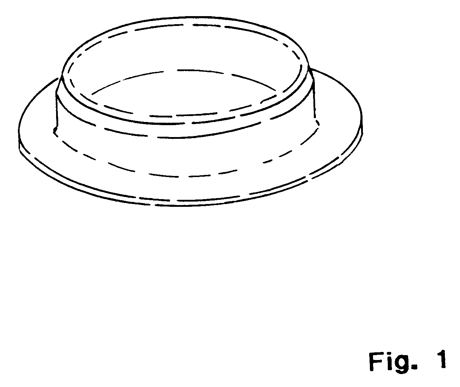

- Figur 1: einen als Flansch ausgebildeten erfindungsgemäßen Formkörper, der die folgenden Abmessungen besitzt:
⌀_{AF} = 285 mm, ⌀_{iF} = 220 mm, d_{F} = 12,7 mm
H = 25,4 mm, H_{St} = 12,7 mm, d_{St} = 4 mm
⌀_{AF} = Außendurchmesser vom Flansch
⌀_{iF} = Innendurchmesser vom Flansch
d_{F} = Dicke vom Flansch
H = Gesamthöhe
H_{St} = Höhe vom Steg
d_{St} = Dicke vom Steg
- Figur 2: ein Diagramm der direkten spektralen Transmission eines Formkörpers nach der Erfindung im Wellenlängebereich λ = 190 nm bis λ = 2650 nm,
- Figur 3: ein Flußdiagramm, das wesentliche Verfahrensschritte des erfindungsgemäßen Verfahrens zeigt,
- Figur 4: einen Vertikalschnitt durch die mit Schlicker gefüllte Form gemäß Ausführungsbeispiel, und
- Figur 5: den Temperaturverlauf als Funktion der Zeit für die Erhitzung des getrockneten Formkörper-Rohlings.

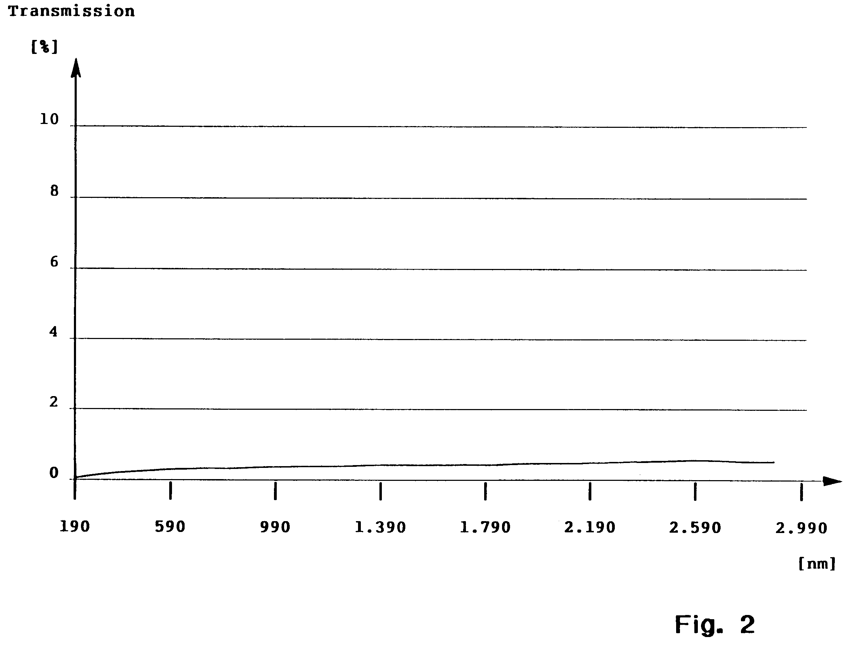

Für den in Figur 2 dargestellten Verlauf der direkten spektralen Transmission wurde ein plättchenförmiger Formkörper mit einer Dicke von 1 mm verwendet. Die Messungen wurden mit einem Spektralphotometer vom Typ Perkin-Elmer LAMBDA 9 ohne Ulbricht-Kugel durchgeführt. Die Oberflächen der Probeformkörper waren poliert. Wie aus dem Kurvenverlauf zu ersehen ist, ist die direkte spektrale Transmission im untersuchten Spektralbereich praktisch konstant und sie liegt unterhalb von 1 %.

Die erfindungsgemäßen Formkörper lassen sich gleich gut mechanisch maschinell bearbeiten wie transparente Quarzglas-Formkörper; sie müssen vor der Bearbeitung jedoch nicht einer Temperung unterworfen werden, wie dies bei transparenten Quarzglas-Formkörpern zur Reduzierung oder Beseitigung von Spannungen erforderlich ist, weil sie praktisch spannungsfrei sind. Auch ist ihre chemische Beständigkeit gleich gut wie diejenige der transparenten Quarzglas-Formkörper. Nach der Verschweißung oder dem Versiegeln ihrer Oberfläche mit einer Feuerpolitur, beispielsweise mittels Gasbrenner, ist kein merkbarer Schwund feststellbar. Die Wärmeleitfähigkeit der Formkörper nach der Erfindung ist etwa gleich derjenigen transparenter Quarzglas-Formkörper.

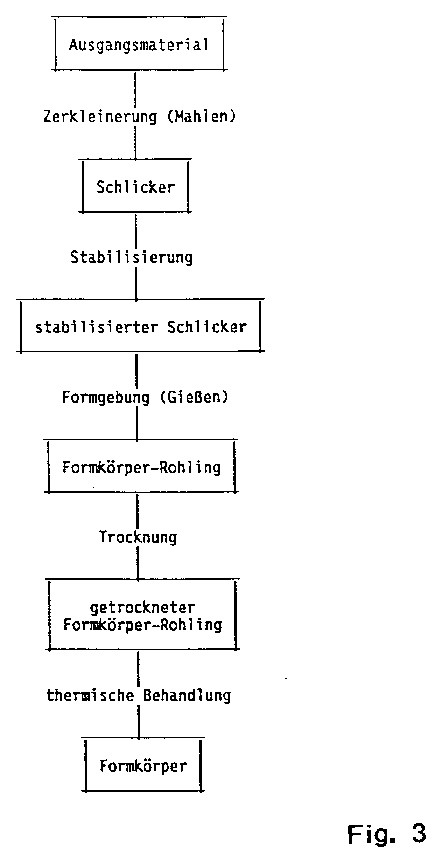

In Figur 3 ist das gesamte Verfahren nochmals in Form eines Flußdiagramms dargestellt, wobei nur die wesentlichen Verfahrensschritte angegeben sind.

Nachfolgend wird anhand eines Ausführungsbeispiels die Herstellung eines ringförmigen Formkörpers mit den Abmessungen ⌀_{A} = 297 mm, ⌀ᵢ = 206 mm, Dicke = 16 mm beschrieben, und zwar unter Bezugnahme auf das Flußdiagramm der Figur 3.

Als Ausgangsmaterial wurde eine Körnung aus amorphem Siliziumdioxid einer chemischen Reinheit von besser als 99,99 % verwendet, die eine Korngrößenverteilung von 80 % im Bereich von 355 bis 2000 µm, von 19 % < 355 µm und 1 % > 2000 µm aufwies.

Diese Körnung wurde in einer allseitig mit Polyurethan ausgekleideten Kugelmühle zusammen mit demineralisiertem Wasser einer Leitfähigkeit von ≤ 0,05 µS gemahlen. Die Mahlkugeln bestanden aus Quarzglas, das eine chemische Reinheit von 99,99 % besaß. Der Mahlversatz setzte sich wie folgt zusammen (in Masse-Prozent):
42 % Körnung,
11 % Wasser,
47 % Mahlkugeln.

Gemahlen wurde dieser Mahlversatz 240 Stunden bei einer Drehgeschwindigkeit von 50 Umdrehungen pro Minute. Nach der Mahlung lag eine Kornverteilung im Bereich von > 0,45 µm bis < 50 µm vor, wobei der Hauptanteil von etwa 60 % zwischen 1 µm und 10 µm lag. Die Analyse der Kornverteilung wurde mittels einem Laserbeugungsspektrometer durchgeführt.

Nach Entfernung der Mahlkörper aus dem Schlicker wurde dieser stabilisiert, indem der Schlicker 240 Stunden in der Kugelmühle mit einer Drehgeschwindigkeit von 50 Umdrehungen pro Minute in Bewegung gehalten wurde. Nach dieser Stabilisierung wurden im Schlicker keine Sedimentationserscheinungen mehr beobachtet. Der Feststoffanteil im Schlicker lag zwischen 78 und 79 %, sein pH-Wert betrug etwa 4,5. Bevor der Schlicker in die Form eingefüllt wurde, wurde er noch 20 Minuten einem Unterdruck von 0,8 bar ausgesetzt, um etwa in dem Schlicker eingeschlossene Luftblasen zu entfernen.

Der so erzeugte Schlicker wurde dann blasenfrei in eine mit Entlüftungskanälen versehene, zuvor mit staubund ölfreier Druckluft und demineralisiertem Wasser (Leitfähigkeit ≤ 0,05 µS) gereinigte Form mit den Abmessungen der Ausnehmung: ⌀_{A} = 315 mm; ⌀ᵢ = 218 mm, Höhe = 17 mm aus handelsüblichem Hartgips (Preßformgips) über einen Zeitraum von 30 Sekunden einlaufenlassen, wobei der sich verringernde Schlickerpegel während drei Stunden in regelmäßigen Intervallen aufgefüllt wurde. Nach einer weiteren dreistündigen Verweilzeit in der Form wurde der gebildete Formkörper-Rohling unter Zufuhr von gereinigter Druckluft in die Entlüftungskanäle der Form entnommen. Während des Einfüllens des Schlickers in die Form sowie während der Verweilzeit in der Form wurde an der nicht mit Schlicker benetzten Außenoberfläche der Form ein Unterdruck von 0,1 bar aufrechterhalten, während der Flüssigkeitsspiegel des Schlickers unter normalem Atmosphärendruck stand.

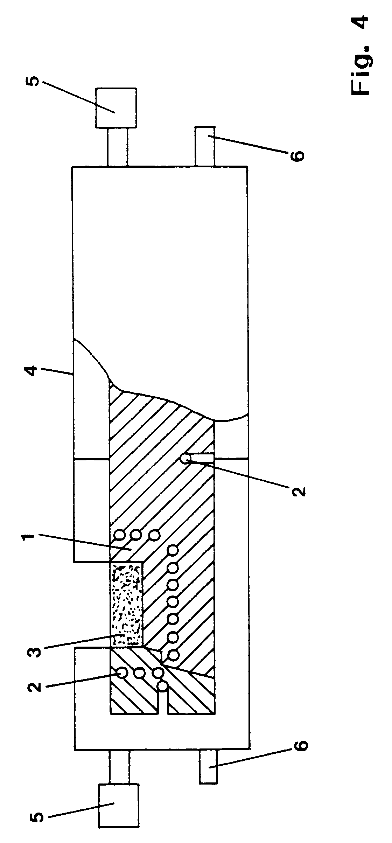

In Figur 4 ist im Vertikalschnitt die mit Schlicker gefüllte Form dargestellt. Mit der Bezugsziffer 1 ist die mit Entlüftungskanälen 2 versehene, mehrteilige Form bezeichnet, deren Ausnehmung mit Schlicker 3 gefüllt ist. Die Form 1 ist gasdicht im Gehäuse 4 angeordnet, das mittels der Pumpe 5 auf einem Unterdruck von 0,1 bar im Inneren gehalten wird. Zur Entnahme des Formkörper-Rohlings wird die Pumpe 5 abgeschaltet und über den Druckluftanschluß 6 Druckluft in das Gehäuse 4 eingeleitet.

Der Formkörper-Rohling wurde anschließend in einem Trockenschrank unter Normalatmosphäre getrocknet. Um eine schonende und störungsfreie Entfernung von Restwasser aus dem Formkörper-Rohling sicher zu gewährleisten, wurde eine stufenweise Erhitzung auf 300 °C durchgeführt, wobei die Temperaturstufen 30, 45, 70, 95, 110, 200 und 300 °C betrugen und die Verweilzeiten des Formkörper-Rohlings auf den genannten Temperaturstufen 15; 15; 15; 15; 15; 8; 8 Stunden betrugen.

Um nach der Trocknung noch geringfügig im Formkörper-Rohling vorhandenes, absorbiertes Restwasser sowie vom Mahlvorgang eventuell vorhandene organische Abriebverunreinigungen zu entfernen, wurde der getrocknete Formkörper-Rohling in einem faserausgekleideten, elektrisch beheizten Ofen unter Luft, wobei der Formkörper-Rohling auf einer zuvor bei 1700 °C ausgeheizten Unterlage aus rekristallisiertem Siliziumkarbid angeordnet war, mit einer Aufheizgeschwindigkeit von 5k/min auf eine Temperatur von 1000°C aufgeheizt und während einer Zeitdauer von 2 Stunden auf dieser Temperatur gehalten. Der Formkörper-Rohling wies danach eine Dichte von 2,0 g/cm³ und eine offenporige Gefügestruktur auf.

Anschließend erfolgte die Hochtemperaturbehandlung des Formkörper-Rohlings im vorbeschriebenen Ofen. Die Aufheizgeschwindigkeit auf die Sintertemperatur von 1400 °C betrug 10 K/min. Die Haltezeit des Formkörper-Rohlings auf der Sintertemperatur betrug 60 Minuten. Danach wurde der Formkörper abgekühlt, und zwar von 1400 °C auf 1000 °C mit einer Abkühlgeschwindigkeit von 10 K/min und danach bis zu seiner Entnahme aus dem Ofen entsprechend der natürlichen Kühlkurve des Ofens, was etwa 8 Stunden dauerte. Der Formkörper wurde bei einer Temperatur von 300 °C dem Ofen entnommen. Seine Dichte wurde mit 2,18 g/cm³ bestimmt.

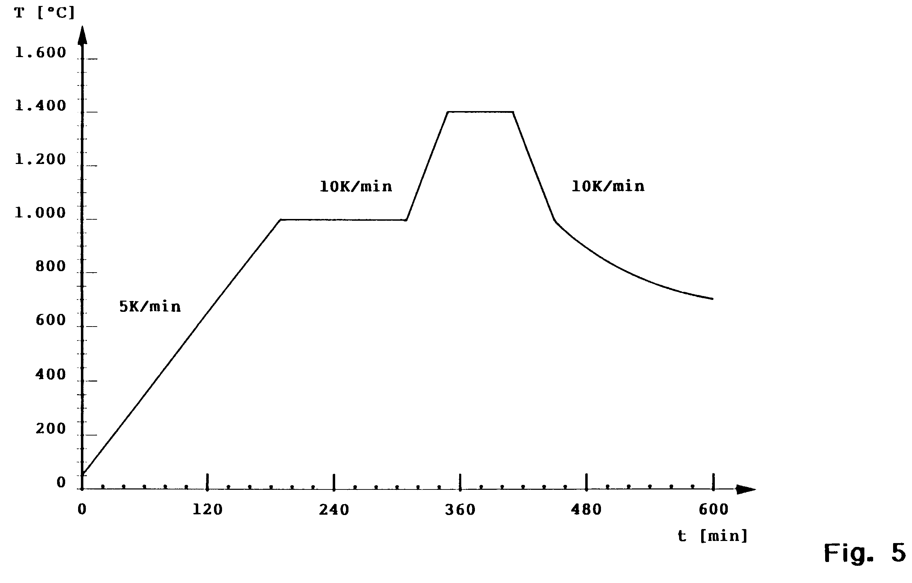

Figur 5 zeigt den Temperaturverlauf als Funktion der Zeit für die Erhitzung des getrockneten Formkörper-Rohlings wie vorstehend beschrieben.

## Patentansprüche

1. Formkörper aus amorphem Siliziumdioxid, der eine chemische Reinheit von mindestens 99,9 % und einen Cristobalitgehalt von höchstens 1 % besitzt und der gasundurchlässig ist, dadurch gekennzeichnet, daß er opak ist, Poren enthält, eine Mindestwandstärke von 0,1 mm besitzt, bei einer Wandstärke von 1 mm seine direkte spektrale Transmission im Wellenlängenbereich von λ = 190 nm bis λ = 2650 nm praktisch konstant ist und unterhalb von 10 % liegt, und daß er eine Dichte aufweist, die wenigstens 2,15 g/cm³ beträgt.

2. Formkörper nach Anspruch 1, dadurch gekennzeichnet, daß mindestens 80 % der Poren eine maximale Porenabmessung von weniger als 20 µm aufweisen.

3. Formkörper nach den Ansprüchen 1 oder 2, dadurch gekennzeichnet, daß sein Porengehalt im Bereich von 0,5 bis 2,5 % pro Volumeneinheit beträgt.

4. Formkörper nach einem der Ansprüche 1 bis 3, dadurch gekennzeichnet, daß er eine Wandstärke im Bereich von 1 bis 100 mm aufweist.

5. Formkörper nach einem der Ansprüche 1 bis 4, dadurch gekennzeichnet, daß er als Hohlkörper ausgebildet ist.

6. Formkörper nach Anspruch 5, dadurch gekennzeichnet, daß er als Flansch ausgebildet ist.

7. Formkörper nach Anspruch 5, dadurch gekennzeichnet, daß er als Tiegel ausgebildet ist.

8. Verfahren zum Herstellen eines gasundurchlässigen Formkörpers aus amorphem Siliziumdioxid, der eine chemische Reinheit von mindestens 99,9 % besitzt und dessen Cristobalitgehalt höchstens 1 % beträgt, wobei als Ausgangsmaterial amorphes Quarzglas einer Reinheit von mindestens 99,9 % zu einem Pulver mit einer Teilchengröße unter 70 µm zerkleinert, und aus dem Pulver ein Schlicker bereitgestellt, der Schlicker zur Erzeugung eines Formkörper-Rohlings in eine poröse, dem Formkörper entsprechende Form eingefüllt und darin eine vorbestimmte Zeit belassen, nach dem Entfernen der Form der Formkörper-Rohling getrocknet und anschließend in einem Ofen auf eine Temperatur über 1200 °C erhitzt und danach abgekühlt wird dadurch gekennzeichnet, daß zur Herstellung eines opaken, Poren enthaltenden Formkörpers, dessen Mindestwandstärke 0.1 mm beträgt und dessen direkte spektrale Transmission bei einer Wandstärke von 1 mm im Wellenlängenbereich λ = 190 nm bis λ = 2650 nm praktisch konstant und unterhalb von 10 % liegt, der Schlicker vor dem Einfüllen in die poröse Form während einer Zeitdauer von 1 bis 240 h durch fortwährendes Inbewegunghalten stabilisiert, der trockene Formkörper-Rohling im Ofen mit einer Aufheizgeschwindigkeit von 5 bis 60.K/min auf eine Sintertemperatur im Bereich von 1350 bis 1450 °C aufgeheizt, einer Temperatur von über 1300 °C während einer Zeitdauer von mindestens 40 min. ausgesetzt und der gesinterte Formkörper mit einer Abkühlgeschwindigkeit von mehr als 5 K/min bis auf eine Temperatur von etwa 1000°C abgekühlt wird.

9. Verfahren nach Anspruch 8, dadurch gekennzeichnet, daß der Schlicker vor dem Einfüllen in die Form kurzzeitig einem Vakuum ausgesetzt wird.

10. Verfahren nach einem der Ansprüche 8 oder 9, dadurch gekennzeichnet, daß während des Einfüllens des Schlickers in die Form und/oder seines Belassens in der Form zwischen freier Schlickeroberfläche und nicht mit Schlicker benetzter Außenoberfläche der Form eine Druckdifferenz aufrechterhalten wird, derart, daß der Druck an der Außenoberfläche niedriger als an der freien Schlickeroberfläche ist.

11. Verfahren nach Anspruch 10, dadurch gekennzeichnet, daß an der Außenoberfläche der Form ein Druck von weniger als 0,8 bar aufrechterhalten wird.

12. Verfahren nach den Ansprüchen 10 oder 11, dadurch gekennzeichnet, daß die Form in einen Behälter eingesetzt wird, der auf einem Druck unter Atmosphärendruck gehalten wird.

13. Verfahren nach einem der Ansprüche 8 bis 12, dadurch gekennzeichnet, daß der Schlicker zur Bildung eines Formkörper-Rohlings für eine Zeitdauer von 5 bis 400 min in der Form belassen wird.

14. Verfahren nach einem der Ansprüche 8 bis 13, dadurch gekennzeichnet, daß der Formkörper-Rohling zur Trocknung von Raumtemperatur auf etwa 300 °C erhitzt wird.

15. Verfahren nach Anspruch 14, dadurch gekennzeichnet, daß die Temperatur stufenweise auf 300 °C erhöht wird.

16. Verfahren nach Anspruch 15, dadurch gekennzeichnet, daß die Höhe der Temperaturstufen im Temperaturbereich unterhalb 100 °C niedriger als im Temperaturbereich von 100 bis 300 °C gewählt wird.

17. Verfahren nach einem der Ansprüche 8 bis 16, dadurch gekennzeichnet, daß die Trocknung des Formkörper-Rohlings unter Vakuum durchgeführt wird.

18. Verfahren nach einem der Ansprüche 8 bis 17, dadurch gekennzeichnet, daß der getrocknete Formkörper-Rohling während einer Zeitdauer von 30 bis 200 min einer Temperatur im Bereich von 900 bis 1100 °C ausgesetzt wird.

19. Verfahren nach einem der Ansprüche 8 bis 18, dadurch gekennzeichnet, daß der Formkörper-Rohling auf der Sintertemperatur während einer Zeitdauer gehalten wird, die um so länger ist je größer die Aufheizgeschwindigkeit ist.

20. Verfahren nach einem der Ansprüche 8 bis 19, daduruch gekennzeichnet, daß zur Hochtemperatursinterung des Formkörper-Rohlings im Ofen eine oxidierende Atmosphäre aufrecherhalten wird.

21. Verfahren nach einem der Ansprüche 8 bis 20, dadurch gekennzeichnet, daß vom abgekühlten Formkörper eine dünne rauhe Sinteroberflächenschicht mechanisch oder durch kurzzeitige Behandlung mittels Fluorwasserstoffsäure abgetragen wird.

22. Verfahren nach einem der Ansprüche 8 bis 21, dadurch gekennzeichnet, daß als Schlicker ein solcher mit einem pH-Wert im Bereich von 3 bis 5 in die Form eingefüllt wird.

23. Verfahren nach einem der Ansprüche 8 bis 21, dadurch gekennzeichnet, daß als Ausgangsmaterial Quarzglasabfälle eingesetzt werden.

## Claims

1. A shaped body of amorphous silica, which body has a chemical purity of at least 99.9% and a cristobalite content of 1% at the most and which is impermeable to gas, characterized in that said body is opaque, contains pores, has a minimum wall thickness of 0.1 mm, at a wall thickness of 1 mm its direct spectral transmission in the wavelength range of λ = 190 nm to λ = 2650 nm is virtually constant and below 10%, and that it has a density which is at least 2.15 g/cm³.

2. The shaped body according to claim 1, characterized in that at least 80% of the pores have a maximum pore dimension of less than 20 µm.

3. The shaped body according to claims 1 or 2, characterized in that its pore content is in the range of 0.5% to 2.5% per volume unit.

4. The shaped body according to any one of claims 1 to 3, characterized in that it has a wall thickness ranging from 1 mm to 100 mm.

5. The shaped body according to any one of claims 1 to 4, characterized in that it is formed as a hollow body.

6. The shaped body according to claim 5, characterized in that it is formed as a flange.

7. The shaped body according to claim 5, characterized in that it is formed as a crucible.

8. A method of making a gas-impermeable shaped body of amorphous silica, which body has a chemical purity of at least 99.9% and whose cristobalite content is 1% at the most, with amorphous quartz glass of a purity of at least 99.9% being comminuted as a starting material to a powder having a particle size of less than 70 µm and a slip being provided from the powder, said slip for producing a shaped-body blank being filled into a porous mold corresponding to the shaped body and being left in said mold for a predetermined period of time, the shaped body blank being dried after removal from the mold and subsequently heated in a furnace to a temperature of more than 1200°C and then cooled, characterized in that for producing an opaque shaped body containing pores, whose minimum wall thickness is 0.1 mm and whose direct spectral transmission in the wavelength range λ = 190 nm to λ = 2650 nm is virtually constant and below 10% at a wall thickness of 1 mm, the slip is stabilized by being constantly moved for a period of 1h to 240 h prior to being filled into the porous mold, the dry body blank is heated in the furnace at a heating rate of 5 K/min to 60 K/min to a sintering temperature ranging from 1350°C to 1450°C and subjected to a temperature of more than 1300°C for a period of at least 40 min, and the sintered shaped body is cooled at a cooling rate of more than 5 K/min to a temperature of about 1000°C.

9. The method according to claim 8, characterized in that prior to being filled into the mold the slip is exposed to a vacuum for a short period of time.

10. The method according to any of claims 8 or 9, characterized in that while the slip is being filled into the mold and/or while being left in the mold, a pressure difference is maintained between free slip surface and outer surface of the mold which is not wetted with slip, in such a manner that the pressure on the outer surface is lower than on the free slip surface.

11. The method according to claim 10, characterized in that a pressure of less than 0.8 bar is maintained on the outer surface of the mold.

12. The method according to claims 10 or 11, characterized in that the mold is inserted into a container which is kept at a pressure below atmospheric pressure.

13. The method according to any one of claims 8 to 12, characterized in that the slip is left in the mold for a period of 5 min to 400 min for forming a shaped-body blank.

14. The method according to any one of claims 8 to 13, characterized in that the shaped-body blank is heated for drying purposes from room temperature up to about 300°C.

15. The method according to claim 14, characterized in that the temperature is stepwise increased to 300°C.

16. The method according to claim 15, characterized in that the level of the temperature stages in the temperature range below 100°C is chosen such that it is lower than in the temperature range of from 100°C to 300°C.

17. The method according to any one of claims 8 to 16, characterized in that the shaped-body blank is dried under vacuum.

18. The method according to any one of claims 8 to 17, characterized in that the dried body blank is exposed to a temperature ranging from 900°C to 1100°C for a period of 30 min to 200 min.

19. The method according to any one of claims 8 to 18, characterized in that the shaped-body blank is kept at the sintering temperature for a period which is the longer the greater the heating rate is.

20. The method according to any one of claims 8 to 19, characterized in that an oxidizing atmosphere is maintained in the furnace for high-temperature sintering the shaped-body blank.

21. The method according to any one of claims 8 to 20, characterized in that a thin rough sintering surface layer is removed from the cooled shaped body mechanically or by short-term treatment with hydrofluoric acid.

22. The method according to any one of claims 8 to 21, characterized in that the slip which is filled into the mold is a slip having a pH ranging from 3 to 5.

23. The method according to any of claims 8 to 21, characterized in that quartz glass waste is used as the starting material.

## Revendications

1. Corps façonné en dioxyde de silicium amorphe, qui possède une pureté chimique d'au moins 99,9 % et une teneur en cristobalite d'au plus 1 % et qui est imperméable aux gaz, caractérisé en ce qu'il est opaque, en ce qu'il contient des pores, en ce qu'il possède une épaisseur minimale de paroi de 0,1 mm, en ce que, pour une épaisseur de paroi de 1 mm, sa transmission spectrale directe dans le domaine de longueurs d'onde de λ = 190 nm à λ = 2 650 nm est pratiquement constante et est située au-dessous de 10 %, et en ce qu'il présente une masse volumique qui est d'au moins 2,15 g/cm³.

2. Corps façonné selon la revendication 1, caractérisé en ce qu'au moins 80 % des pores présentant une dimension maximale de pore inférieure à 20 µm.

3. Corps façonné selon les revendications 1 ou 2, caractérisé en ce que sa teneur en pores est dans le domaine de 0,5 à 2,5 % par unité de volume.

4. Corps façonné selon l'une des revendications 1 à 3, caractérisé en ce qu'il présente une épaisseur de paroi dans le domaine de 1 à 100 mm.

5. Corps façonné selon l'une des revendications 1 à 4, caractérisé en ce qu'il est sous forme de corps creux.

6. Corps façonné selon la revendication 5, caractérisé en ce qu'il est sous forme de bride.

7. Corps façonné selon la revendication 5, caractérisé en ce qu'il est sous forme de creuset.

8. Procédé de fabrication d'un, corps façonné imperméable aux gaz en dioxyde de silicium amorphe, qui possède une pureté chimique d'au moins 99,9 % et dont la teneur en cristobalite est d'au plus 1 %, où du verre de quartz amorphe d'une pureté d'au moins 99,9 %, en tant que matière première, est broyé en une poudre ayant une taille de particules inférieure à 70 µm, et une suspension est préparée à partir de la poudre, la suspension est introduite dans un moule poreux correspondant au corps façonné pour la production d'une ébauche de corps façonné et y est laissée pendant une durée prédéterminée, après le retrait du moule, l'ébauche de corps façonné est séchée puis chauffée dans un four à une température supérieure à 1 200°C et ensuite refroidie, caractérisé en ce que, pour la fabrication d'un corps façonné opaque contenant des pores dont l'épaisseur minimale de paroi est de 0,1 mm et dont la transmission spectrale directe pour une épaisseur de paroi de 1 mm dans le domaine de longueurs d'onde λ = 190 nm à λ = 2 650 nm est pratiquement constante et inférieure à 10 %, la suspension est stabilisée pendant une durée de 1 à 240 h par maintien continu en mouvement avant l'introduction dans le moule poreux, l'ébauche de corps façonné sèche est chauffée dans le four à une vitesse de chauffage et 5 à 60 K/min à une température de frittage dans le domaine de 1 350 à 1 450°C, est exposée à une température supérieure à 1 300°C pendant une durée d'au moins 40 min, et le corps façonné fritté est refroidi jusqu'à une température d'environ 1 000°C à une vitesse de refroidissement supérieure à 5 K/min.

9. Procédé selon la revendication 8, caractérisé en ce que la suspension est exposée pendant une courte durée à un vide avant l'introduction dans le moule.

10. Procédé selon l'une des revendications 8 ou 9, caractérisé en ce que, pendant l'introduction de la suspension dans le moule et/ou pendant son séjour dans le moule, une différence de pression est maintenue entre la surface libre de la suspension et la surface externe du moule qui n'est pas mouillée par la suspension de telle manière que la pression sur la surface externe est plus basse que sur la surface libre de la suspension.

11. Procédé selon la revendication 10, caractérisé en ce qu'une pression inférieure à 0,8 bar est maintenue sur la surface externe du moule.

12. Procédé selon les revendications 10 ou 11, caractérisé en ce que le moule est disposé dans un récipient qui est maintenu à une pression inférieure à la pression atmosphérique.

13. Procédé selon l'une des revendications 8 à 12, caractérisé en ce que la suspension pour la formation d'une ébauche de corps façonné est laissée dans le moule pendant une durée de 5 à 400 min.

14. Procédé selon l'une des revendications 8 à 13, caractérisé en ce que l'ébauche de corps façonné est chauffée de la température ambiante à environ 300°C pour le séchage.

15. Procédé selon la revendication 14, caractérisé en ce que la température est augmentée à 300°C par pas.

16. Procédé selon la revendication 15, caractérisé en ce que la hauteur des pas de température est choisie plus basse dans le domaine de température inférieur à 100°C que dans le domaine de température de 100 à 300°C.

17. Procédé selon l'une des revendications 8 à 16, caractérisé en ce que le séchage de l'ébauche de corps façonné est réalisé sous vide.

18. Procédé selon l'une des revendications 8 à 17, caractérisé en ce que l'ébauche de corps façonné séchée est exposée pendant une durée de 30 à 200 min à une température dans le domaine de 900 à 1 100°C.

19. Procédé selon l'une des revendications 8 à 18, caractérisé en ce que l'ébauche de corps façonné est maintenue à la température de frittage pendant une durée qui est d'autant plus longue que la vitesse de chauffage est grande.

20. Procédé selon l'une des revendications 8 à 19, caractérisé en ce qu'une atmosphère oxydante est maintenue dans le four pour le frittage à haute température de l'ébauche de corps façonné.

21. Procédé selon l'une des revendications 8 à 20, caractérisé en ce qu'une mince couche superficielle de frittage rugueuse est retirée du corps façonné refroidi, mécaniquement ou par un court traitement à l'aide d'acide fluorhydrique.

22. Procédé selon l'une des revendications 8 à 21, caractérisé en ce que l'on introduit comme suspension dans le moule une suspension ayant un pH dans le domaine de 3 à 5.

23. Procédé selon l'une des revendications 8 à 21, caractérisé en ce que l'on utilise des déchets de verre de quartz comme matière première.
